# EUROPEAN PATENT APPLICATION

(11) **EP 4 468 338 A1**
(43) Date of publication of application: **27.11.2024**
(21) Application number: 23743153.1
(22) Date of filing: 11.01.2023
(51) Int. Cl.: H01L 23/473, B29C 45/14, B29C 70/68, F28D 15/02, H01M 10/613, H01M 10/653, H01M 10/6554, H05K 7/20

(54) **TEMPERATURE CONTROL DEVICE AND METHOD FOR MANUFACTURING TEMPERATURE CONTROL DEVICE**

(30) Priority: 19.01.2022 JP 2022006623
(71) Applicant: Mitsui Chemicals, Inc., Tokyo 104-0028 (JP)
(72) Inventor: TOMINAGA, Takahiro, Sodegaura-shi, Chiba 299-0265 (JP); MORIMOTO, Kai, Sodegaura-shi, Chiba 299-0265 (JP)
(74) Representative: J A Kemp LLP
(86) International application number: PCT/JP2023/000499
(87) International publication number: WO 2023/140158

(57) **Abstract**

The temperature control device of the disclosure includes: a pair of metal plates; a resin flow path wall part sandwiched between the pair of metal plates; and a resin fixing part fixing one of the pair of metal plates to the other metal plate. Regarding the resin flow path wall part, an internal flow path for circulating a heat exchange medium is formed by at least one of the pair of metal plates and the resin flow path wall part. The resin fixing part and the resin flow path wall part are fused together. The crystallinity of the resin flow path wall part is lower than the crystallinity of the resin fixing part. A difference between the crystallinity of the resin flow path wall part and the crystallinity of the resin fixing part is 3% or more.

## Description

### Technical Field

The present disclosure relates to: a temperature control device; and a method of producing a temperature control device.

### Background Art

Central processing units (CPUs) installed in computers and secondary batteries mounted on electric vehicles generate heat during operation. As means for cooling these heat-generating bodies, various cooling devices using a cooling medium have been proposed.

Patent Document 1 proposes a cooling device for cooling a heat-generating body. The cooling device disclosed in Patent Document 1 includes a resin flow path, a metal cooling panel, and a resin bonding member. A void space serving as a flow path is provided on at least one surface of a resin flow path wall part. The metal cooling panel covers this void space and at least partially contacts the resin flow path. The metal cooling panel cools a heat-generating body. The resin bonding member bonds the resin flow path with the metal cooling panel. The metal cooling panel has a fine uneven structure at least on a surface of a part bonded with the resin bonding member. The metal cooling panel and the resin bonding member are bonded with each other by allowing a part of the resin bonding member to be incorporated into the fine uneven structure.

Patent Document 1: WO 2020/255885

### SUMMARY OF THE INVENTION

### Technical Problem

In the cooling device disclosed in Patent Document 1, a resin member having a refrigerant flow path is formed individually by injection molding or the like. Therefore, the degree of freedom in the design of an internal flow path is excellent.

On the other hand, in the cooling device disclosed in Patent Document 1, a cooling medium for cooling the heat-generating body is pressurized and circulated in an internal flow path. In this process, the occurrence of a defect (e.g., a gap) in a bonding portion (hereinafter, also referred to as "joint") between the resin flow path and the resin bonding member may lead to leakage of the cooling medium from the joint to the outside of the cooling device. Therefore, a cooling device in which such a defect is less likely to occur in a joint (i.e., a cooling medium having an excellent air tightness) is demanded.

In view of the above-described circumstances, an object of the disclosure is to provide: a temperature control device having an excellent degree of freedom in the design of an internal flow path as well as an excellent air tightness; and a method of producing a temperature control device.

### Solution to Problem

Means for solving the above-described problems encompass the following embodiments.
<1> A temperature control device, including:
   a pair of metal plates;
   a resin flow path wall part sandwiched between the pair of metal plates; and
   a resin fixing part fixing one of the pair of metal plates to the other metal plate, wherein:
      an internal flow path for circulating a heat exchange medium is formed by at least one of the pair of metal plates and the resin flow path wall part,
      the resin fixing part and the resin flow path wall part are fused together,
      the crystallinity of the resin flow path wall part as measured by X-ray diffractometry is lower than the crystallinity of the resin fixing part as measured by X-ray diffractometry, and
      a difference between the crystallinity of the resin flow path wall part and the crystallinity of the resin fixing part is 3% or more.
<2> A temperature control device, including:
   a pair of metal plates;
   a resin flow path wall part sandwiched between the pair of metal plates; and
   a resin fixing part fixing one of the pair of metal plates to the other metal plate, wherein:
      an internal flow path for circulating a heat exchange medium is formed by at least one of the pair of metal plates and the resin flow path wall part,
      the resin fixing part and the resin flow path wall part are fused together,
      the crystallinity of the resin flow path wall part as measured by X-ray diffractometry is lower than the crystallinity of the resin fixing part as measured by X-ray diffractometry,
      the resin flow path wall part contains a crosslinked-type thermoplastic resin, and
      the resin fixing part contains a linear-type thermoplastic resin.
<3> The temperature control device according to <1> or <2>, wherein:
   the resin flow path wall part contains a crosslinked-type polyphenylene sulfide, and
   the resin fixing part contains a linear-type polyphenylene sulfide.
<4> A temperature control device, including:
   a pair of metal plates;
   a resin flow path wall part sandwiched between the pair of metal plates; and
   a resin fixing part fixing one of the pair of metal plates to the other metal plate, wherein:
      an internal flow path for circulating a heat exchange medium is formed by at least one of the pair of metal plates and the resin flow path wall part,
      the resin fixing part and the resin flow path wall part are fused together,
      the resin flow path wall part contains a crosslinked-type polyphenylene sulfide, and
      the resin fixing part contains a linear-type polyphenylene sulfide.
<5> The temperature control device according to any one of <1> to <4>, wherein a fine uneven structure at a portion that contacts the resin fixing part.
<6> The temperature control device according to any one of <1> to <5>, wherein the resin fixing part is formed by insert molding.
<7> The temperature control device according to any one of <1> to <6>, wherein a portion of the resin flow path wall part that contacts the resin fixing part has an arithmetic mean roughness Ra of from 0.5 µm to 100 µm.
<8> The temperature control device according to any one of <1> to <7>, having a tensile strength of from 200 N to 550 N,
   wherein the tensile strength represents a maximum value of tensile strength required for breaking the resin fixing part, which has a size of 7 mm × 4 mm from the resin flow path wall part under conditions of a temperature of 23°C, a chuck distance of 50 mm, and a tensile speed of 2 mm/min.
<9> A method of producing a temperature control device, which is a method of producing the temperature control device according to any one of <1> to <8>, the method including preparing the resin flow path wall part by injection molding, wherein:
   an inner surface of a mold used for the injection molding includes a molding surface for molding a portion of the resin flow path wall part that contacts the resin fixing part, and
   the molding surface has a fine uneven structure.
<10> The method of producing a temperature control device according to <9>, including performing a roughening treatment on the portion of the resin flow path wall part that contacts the resin fixing part.

### Advantageous Effects of Invention

According to the disclosure, a temperature control device having an excellent degree of freedom in the design of an internal flow path as well as an excellent air tightness, and a method of producing a temperature control device are provided.

### BRIEF DESCRIPTION OF DRAWINGS

FIG. 1 is a perspective view illustrating the outer appearance of one example of the temperature control device according to a first embodiment of the disclosure;
FIG. 2 is another perspective view illustrating the outer appearance of one example of the temperature control device according to the first embodiment of the disclosure;
FIG. 3 is a cross-sectional view taken along the III-III line of FIG. 1;
FIG. 4 is a cross-sectional view taken along the IV-IV line of FIG. 1;
FIG. 5 is a perspective view showing the outer appearance of a second metal plate and a partition member in one example of the temperature control device according to the first embodiment of the disclosure;
FIG. 6 is an image of an upper surface of a second test specimen of Example 1 in the vicinity of a tab;
FIG. 7 is an image of a fractured surface of the second test specimen of Example 1;
FIG. 8 is an image of a fractured surface of a second test specimen of Comparative Example 1;
FIG. 9 is an image of a fractured surface of a second test specimen of Comparative Example 2; and
FIG. 10 is a schematic front view of a molding surface of a mold, illustrating a method of measuring the surface roughness Ra.

### DESCRIPTION OF EMBODIMENTS

In the present specification, those numerical ranges that are expressed with "to" each denote a range that includes the numerical values stated before and after "to" as the minimum value and the maximum value, respectively.

The term "step" used herein encompasses not only a discrete step but also a step that cannot be clearly distinguished from other steps, as long as the intended purpose of the step is achieved.

Embodiments of the temperature control device and the method of producing a temperature control device according to the disclosure will now be described referring to the drawings. In the drawings, the same or corresponding parts are denoted by the same reference symbol, and description thereof is not repeated.

### (1) First Embodiment

The temperature control device according to a first embodiment of the disclosure is used for controlling the temperature of at least one heat exchange object. Specifically, the temperature control device thermally contacts the heat exchange object, and thereby draws heat from the heat exchange object or provides heat to the heat exchange object.

The heat exchange object is not particularly limited, and examples thereof include CPUs, memory modules, battery modules, and power modules. Examples of the memory modules include dual inline memory modules (DIMMs). Examples of the battery modules include lithium ion battery modules.

The temperature control device according to the first embodiment includes a pair of metal plates, a resin flow path wall part, and a resin fixing part. The resin flow path wall part is sandwiched between the pair of metal plates. The resin fixing part fixes one of the pair of metal plates to the other metal plate. An internal flow path for circulating a heat exchange medium is formed by at least one of the pair of metal plates and the resin flow path wall part. The resin fixing part and the resin flow path wall part are fused together. The crystallinity of the resin flow path wall part as measured by X-ray diffractometry is lower than the crystallinity of the resin fixing part as measured by X-ray diffractometry. A difference between the crystallinity of the resin flow path wall part and the crystallinity of the resin fixing part (hereinafter, also referred to as "difference in crystallinity") is 3% or more.

In the disclosure, the "internal flow path" refers to a space for circulating a heat exchange medium.

The phrase "the resin fixing part and the resin flow path wall part are fused together" indicates that the resin flow path wall part and the resin fixing part are anchored with each other at room temperature (e.g., 23°C) without an adhesive, a screw, or the like. In other words, the phrase "the resin fixing part and the resin flow path wall part are fused together" indicates that a resin component of the resin flow path wall part and a resin component of the resin fixing part are compatible with each other. The term "compatible" used herein refers to that, in an atmosphere where the resin components constituting the resin fixing part and the resin flow path wall part are melted, these resin components are mixed with each other without being separated.

The "crystallinity" refers to a ratio of the mass of crystal portion of a resin (i.e., polymer solid) with respect to a total mass of the resin, and is determined from the intensity of X-ray scattered by the crystal portion. A method of determining each of the "crystallinity of the resin flow path wall part" and the "crystallinity of the resin fixing part" is the same as the method described below in the section of Examples.

The temperature control device according to the first embodiment has the above-described configuration and is, therefore, excellent in terms of the degree of freedom in the design of the internal flow path as well as the air tightness.

This effect is presumably attributed to, but not limited to, the following reasons.

The temperature control device according to the first embodiment includes the resin flow path wall part. In other words, the resin flow path wall part is molded individually. Thus, the degree of freedom in the design of the internal flow path is excellent as compared to a case of using a flow path wall part made of a metal.

The crystallinity of the resin flow path wall part is lower than the crystallinity of the resin fixing part. The difference in crystallinity is 3% or more. In other words, a ratio of amorphous portion of the resin flow path wall part (i.e., a ratio of the mass of amorphous portion of the resin flow path wall part with respect to a total mass of the resin flow path wall part) is higher than a ratio of amorphous portion of the resin fixing part. Generally, between resins that are compatible, a resin having a higher ratio of amorphous portion melts more easily than the other resin having a lower ratio of amorphous portion. Accordingly, in the first embodiment, the resin flow path wall part and the resin fixing part are more likely to be fused together as compared to when the difference in crystallinity, which is calculated by subtracting the crystallinity of the resin flow path wall part from the crystallinity of the resin fixing part, is less than 3%. In this case, it is believed that the molecular chains of the resin constituting the resin flow path wall part and the molecular chains of the resin constituting the resin fixing part are entangled with each other in a greater amount. Further, since the resin fixing part, which has a high crystallinity is integrally molded with the resin flow path wall part, it is believed that crystals are likely to be formed in a fused portion of the resin flow path wall part and the resin fixing part. By this, the strength of the fusion between the resin flow path wall part and the resin fixing part (hereinafter, also referred to as "fusion strength") is improved. In other words, even when a pressurized heat exchange medium is circulated in the internal flow path, a defect is unlikely to occur in the fused portion of the resin flow path wall part and the resin fixing part. As a result, the heat exchange medium is unlikely to leak from the fused portion. Therefore, the temperature control device according to the first embodiment has an excellent air tightness.

For these reasons, it is presumed that the temperature control device according to the first embodiment has an excellent degree of freedom in the design of the internal flow path, as well as an excellent air tightness.

One example of a method of controlling the crystallinity of the resin flow path wall part to be lower than the crystallinity of the resin fixing part and adjusting the difference in crystallinity to be in the above-described range is a method of selecting the types of resin components constituting each of the resin flow path wall part and the resin fixing part as appropriate.

In the first embodiment, the difference in crystallinity is 3% or more. By this, the fusion strength is further improved. As a result, the temperature control device has a superior air tightness. When the crystallinity of the resin component of the resin flow path wall part is excessively low, the thermal characteristics and the mechanical properties of the resin flow path wall part tend to be deteriorated. Therefore, it is preferred that the crystallinity of the resin component of the resin flow path wall part is not excessively low within a range where the above-described difference in crystallinity is satisfied.

From the standpoint of, for example, further improving the air tightness of the temperature control device, the difference in crystallinity is preferably from 3% to 15%, more preferably from 3% to 8%.

A shape and a size of the temperature control device are not particularly limited, and are selected as appropriate in accordance with the type and the like of the heat exchange object. For example, the temperature control device has a rectangular parallelepiped shape.

### (1.1) Pair of Metal Plates

Each of the pair of metal plates is a plate-like material made of a metal. Each of the pair of metal plates may have the same configuration, or different configurations.

Each of the pair of metal plates may each have, for example, a flat plate shape. A size of the pair of metal plates is selected as appropriate in accordance with the heat exchange obj ect.

A metal constituting the pair of metal plates is not particularly limited, and examples thereof include iron, copper, nickel, gold, silver, platinum, cobalt, zinc, lead, tin, titanium, chromium, aluminum, magnesium, manganese, and alloys of these metals (e.g., stainless steel, brass, and phosphor bronze). Thereamong, from the standpoint of thermal conductivity, the metal material constituting the pair of metal plates is preferably aluminum, an aluminum alloy, copper, or a copper alloy, more preferably copper or a copper alloy. From the standpoint of reducing the weight and ensuring the strength, the metal material constituting the pair of metal plates is preferably aluminum or an aluminum alloy.

It is preferred that each of the pair of metal plates has a fine uneven structure (hereinafter, also referred to as "first uneven structure") at a portion that contacts the resin fixing part. This allows the resin fixing part to be partially incorporated into recesses of the first uneven structure of each of the pair of metal plates. As a result, the pair of metal plates are more strongly bonded with the resin fixing part. Therefore, the air tightness of the temperature control device can be maintained over a longer period.

A state of the first uneven structure is not particularly limited as long as a sufficient bonding strength between the pair of metal plates and the resin fixing part (hereinafter, also simply referred to as "bonding strength") is obtained.

In the first uneven structure, the recesses have an average pore size of preferably from 5 nm to 500 µm, more preferably from 10 nm to 150 µm, still more preferably from 15 nm to 100 µm.

In the first uneven structure, the recesses have an average pore depth of preferably from 5 nm to 500 µm, more preferably from 10 nm to 150 µm, still more preferably from 15 nm to 100 µm.

When at least one of the average pore size or the average pore depth of the recesses in the first uneven structure is in the above-described range, a higher bonding strength tends to be obtained.

The average pore size and the average pore depth of the recesses are determined by a method according to JIS B0601-2001.

The first uneven structure is formed by performing a roughening treatment on the surfaces of the pair of metal plates. A method of performing the roughening treatment on the surfaces of the metal members is not particularly limited, and a variety of known methods may be employed.

From the standpoint of improving the bonding strength, the surfaces of the pair of metal plates may be further subjected to a functional group addition treatment. For this functional group addition treatment, a variety of known methods may be employed.

At least one of the pair of metal plates is thermally brought into contact the heat exchange object. This allows the temperature control device to efficiently control the temperature of the heat exchange object.

The pair of metal plates may thermally contact the heat exchange object via, for example, a thermally conductive layer. The thermally conductive layer is not particularly limited, and may be a thermally conductive sheet or a thermally conductive material (TIM: Thermal Interface Material) layer. The "thermally conductive material layer" refers to a layer formed by applying a thermally conductive material. Examples of the thermally conductive material include a thermally conductive grease, a thermally conductive gel, a thermally conductive adhesive, and a phase change material.

### (1.2) Resin Flow Path Wall Part

The resin flow path wall part constitutes a portion of a wall part forming the internal flow path. The resin flow path wall part is, for example, a cylindrical or plate-like material made of a resin.

A shape and a size of the resin flow path wall part are selected as appropriate in accordance with the type of the heat exchange object.

The resin flow path wall part is, for example, a molded body of a first thermoplastic resin composition. Examples of the resin flow path wall part include an injection-molded product and a press-molded product.

An arithmetic mean roughness Ra of a portion (i.e., surface) of the resin flow path wall part that contacts the resin fixing part (hereinafter, also referred to as "contact portion of the resin flow path wall part") is not particularly limited, and it is preferably from 0.5 µm to 100 µm. This allows the contact portion of the resin flow path wall part to have a larger surface area as compared to a case where the arithmetic mean roughness Ra of the contact portion of the resin flow path wall part is outside the range of from 0.5 µm to 100 µm. As a result, the fusion strength is improved.

From the standpoint of further improving the fusion strength, the arithmetic mean roughness Ra of the contact portion of the resin flow path wall part is more preferably from 1 µm to 60 µm, still more preferably from 5 µm to 30 µm.

The arithmetic mean roughness (Ra) is determined by a method according to JIS B0601.

The first thermoplastic resin composition contains a thermoplastic resin as a resin component.

Examples of the thermoplastic resin include polyphenylene sulfides (hereinafter, also referred to as "PPSs"), polyolefin resins, polyvinyl chlorides, polyvinylidene chlorides, polystyrene resins, acrylonitrile-styrene copolymer (AS) resins, acrylonitrile-butadienestyrene copolymer (ABS) resins, polyester resins, poly(meth)acrylic resins, polyvinyl alcohols, polycarbonate resins, polyamide resins, polyimide resins, polyether resins, polyacetal resins, fluorocarbon resins, polysulfone resins, and polyketone resins. Thereamong, from the standpoint of heat resistance, rigidity, chemical resistance, flame retardancy, and the like, the thermoplastic resin is preferably a PPS.

PPSs, which are crystalline polymers, are broadly classified into so-called crosslinked-type PPSs and linear-type PPSs based on the production process.

A crosslinked-type PPS is a PPS whose molecular weight has been increased by a heat treatment or the like. A crosslinked-type PPS is believed to have a long-chain branched structure, rather than a network crosslinked structure such as that of a thermosetting resin. A crosslinked-type PPS can be obtained by, for example, performing polymerization by a method based on a reaction between a halogen-substituted aromatic compound and an alkali sulfide (U.S. Patent No. 2513188 or Japanese Patent Publication (JP-B) No. S45-3368), and subsequently crosslinking the resultant.

A linear-type PPS is, for example, a linear polymer whose molecular weight has been increased in the polymerization stage.

The crystallinity of a linear-type PPS tends to be higher than that of a crosslinked-type PPS. The melting point of a linear-type PPS tends to be lower than that of a crosslinked-type PPS.

A crosslinked-type PPS tends to be superior to a linear-type PPS in terms of high-temperature rigidity and creep resistance. A crosslinked-type PPS tends to have a lower tensile strength than a linear-type PPS.

From the standpoint of, for example, improving the mechanical properties of the resin flow path wall part, the first thermoplastic resin composition may contain a filler. Examples of the filler include various fibers, such as glass fibers, carbon fibers, and cellulose fibers, as well as carbon nanotubes (CNTs), graphenes, carbon particles, clay, talc, silica, and minerals. These fillers may be used singly, or in combination of two or more kinds thereof. When the first thermoplastic resin composition contains a filler, the content thereof is preferably from 15% by mass to 60% by mass, more preferably from 30% by mass to 55% by mass, with respect to a total amount of the first thermoplastic resin composition.

From the standpoint of, for example, imparting a desired function to the resin flow path wall part, the first thermoplastic resin composition may further contain an additive. Examples of the additive include heat stabilizers, antioxidants, pigments, anti-weathering agents, flame retardants, plasticizers, dispersants, lubricants, mold release agents, and antistatic agents. These additives may be used singly, or in combination of two or more kinds thereof.

The first thermoplastic resin composition may be a commercially available product. Examples of a commercially available product of the first thermoplastic resin composition containing a PPS as a thermoplastic resin include SUSTEEL (registered trademark) Series (e.g., "SGX-115", "SGX-120", and "SGX-140") manufactured by Tosoh Corporation, and DURAFIDE (registered trademark) (e.g., "1135MF1", "1140A6", and "1150MF1") manufactured by Polyplastics Co., Ltd.

### (1.3) Resin Fixing Part

The resin fixing part fixes one of the pair of metal plates to the other metal plate. The resin fixing part is a fixing part made of a resin.

A shape and a size of the resin fixing part are not particularly limited, and are selected as appropriate in accordance with the pair of metal plates, the resin flow path wall part, and the like.

The resin fixing part may be formed by insert molding or welding.

In the insert molding, a layered body of the pair of metal plates and the resin flow path wall part is inserted into a mold, and a melt of the resin fixing part is injected to a prescribed part of the outer surface of the layered body to form the resin fixing part.

Examples of the welding include heat welding, vibration welding, laser welding, ultrasonic welding, and hot plate welding.

The resin fixing part is preferably formed by insert molding. By this, as compared to a case where the resin fixing part is formed by welding, the resin fixing part is more certainly incorporated into the gaps of the uneven parts of the surfaces contacting each of the pair of metal plates. Therefore, the resin fixing part is more strongly anchored with the pair of metal plates. As a result, the air tightness of the temperature control device can be maintained over a longer period.

The resin fixing part is a molded body of a second thermoplastic resin composition. The second thermoplastic resin composition is selected as appropriate in accordance with the first thermoplastic resin composition and the like.

The second thermoplastic resin composition contains a thermoplastic resin compatible with the resin component of the first thermoplastic resin composition. This allows the resin fixing part and the resin flow path wall part to be fused together.

Examples of the thermoplastic resin compatible with the resin component of the first thermoplastic resin composition include the same resins as those exemplified above as thermoplastic resins.

From the standpoint of, for example, improving the mechanical properties of the resin flow path wall part, the second thermoplastic resin composition may contain at least one of a filler or an additive. Examples of the filler and the additive include the same ones as those exemplified above as fillers and additives that may be contained in the first thermoplastic resin composition. When the second thermoplastic resin composition contains a filler, the content thereof is preferably from 15% by mass to 60% by mass, more preferably from 20% by mass to 40% by mass, with respect to a total amount of the second thermoplastic resin composition.

It is preferred that the resin flow path wall part contains a crosslinked-type PPS while the resin fixing part contains a linear-type PPS. This allows the resin flow path wall part to melt more easily than the resin fixing part. Therefore, as described above, the strength of a fused portion of the resin flow path wall part and the resin fixing part is further improved. As a result, the temperature control device according to the first embodiment has a superior air tightness.

The tensile strength is preferably from 200 N to 600 N. This tensile strength represents a maximum value of tensile strength required for breaking the resin fixing part, which has a size of 7 mm × 4 mm, from the resin flow path wall part under conditions of a temperature of 23°C, a chuck distance of 50 mm, and a tensile speed of 2 mm/min. A tensile strength of from 200 N to 550 N means a superior fusion strength.

The tensile strength is more preferably from 250 N to 550 N, still more preferably from 270 N to 500 N.

The tensile strength is measured in the same manner as the method described below in the section of Examples.

### (1.4) Internal Flow Path

The temperature control device includes an internal flow path for circulating a heat exchange medium. The heat exchange medium exchanges heat with a heat exchange object.

A shape of the internal flow path is not particularly limited, and is selected as appropriate in accordance with the heat exchange object and the like.

The heat exchange medium is a cooling medium or a heating medium, and it is selected as appropriate in accordance with the type and the like of the heat exchange object.

The "cooling medium" refers to a medium used for drawing heat from the heat exchange object. The cooling medium is, for example, a cooling liquid or a cooling gas. The cooling liquid is not particularly limited as long as it is a liquid generally used for cooling, and examples thereof include water, oils, glycol-based aqueous solutions, air conditioner refrigerants, non-electroconductive liquids, and phase change liquids. Examples of the cooling gas include air and nitrogen gas. The temperature of the cooling medium is adjusted as appropriate in accordance with the type and the like of the heat exchange object.

The "heating medium" refers to a medium used for providing heat to the heat exchange object. The heating medium is, for example, a heating liquid or a heating gas. The heating liquid is not particularly limited as long as it is a liquid generally used as a heating liquid, and examples thereof include water, oils, glycol-based aqueous solutions, air conditioner refrigerants, non-electroconductive liquids, and phase change liquids. Examples of the heating gas include air and water vapor. The temperature of the heating medium is adjusted as appropriate in accordance with the type and the like of the heat exchange object.

The feature that the temperature control device includes the internal flow path indicates that the temperature control device has a supply port and a collection port. The supply port and the collection port are in communication via the internal flow path.

The supply port is a part connected with an external supply component. The supply port guides the heat exchange medium supplied from the supply component into the internal flow path. The supply component supplies the heat exchange medium to the temperature control device.

The collection port is a part connected with a collection component. The collection port guides the heat exchange medium in the internal flow path to the external collection component. This collection component collects the heat exchange medium from the temperature control device.

The supply port and the collection port (hereinafter, collectively referred to as "supply port and the like") may each have a connection component. One example of the connection component is a mail connector (nipple). When the supply port and the like do not have a connection component, the temperature control device may be processed for connecting each of the supply component and the collection component. One example of a processing method is threading.

When the temperature control device has a rectangular parallelepiped shape with two main surfaces, the supply port and the collection port may each be arranged on any of the two main surfaces and four side surfaces. For example, the supply port and the collection port may be arranged on the same main surface or different main surfaces, or may each be arranged only on a side surface of the temperature control device.

The supply port and the like may be constituted by the resin flow path wall part, or may be constituted by at least one of the pair of metal plates.

### (1.5) Partition Member

The temperature control device may further include a partition member. The partition member divides the internal flow path and controls the flow direction of the heat exchange medium circulating in the internal flow path. This enables to design the internal flow path more freely.

In the internal flow path, the partition member is arranged between the pair of metal plates. The partition member is fixed to at least one of the pair of metal plates by, for example, the resin fixing part.

When the partition member is fixed to one of the pair of metal plates, the partition member may or may not contact the other metal plate. When the partition member contacts the other metal plate and is made of a resin, the partition member fixed to one of the pair of the metal plates may be bonded to the other metal plate.

The partition member may be made of a resin or a metal. When the partition member is made of a metal, the partition member can also function as a fin to improve the heat exchange efficiency. Examples of the resin constituting the partition member include the same resins as those exemplified above as the resin constituting the resin flow path wall part. Examples of the metal constituting the partition member include the same metals as those exemplified above as the metal constituting the pair of metal plates.

A method of fixing the partition member to at least one of the pair of metal plates (hereinafter, also referred to as "fixing method") is selected as appropriate in accordance with the material of the partition member, and examples of the method include a fusing method, a method using a known additive, a method using a fastening component (hereinafter, also referred to as "mechanical fastening"), and a welding method. These fixing methods may be employed singly, or in combination of two or more kinds thereof. Examples of the fastening component include a volt, a nut, a screw, a rivet, and a pin. Examples of the welding method include metal welding and brazing. When the partition member is made of a metal, the partition member and at least one of the pair of metal plates may be an integrally molded product. When the partition member is made of a resin, the partition member and the resin flow path wall part may be an integrally molded product.

### (1.6) One Example of First Embodiment

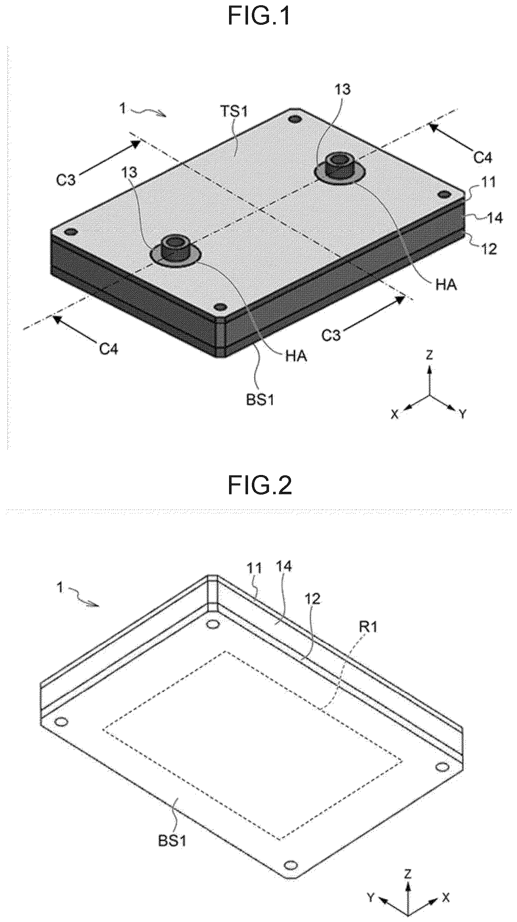

One example of the temperature control device according to the first embodiment of the disclosure will now be described referring to FIGs. 1 to 5.

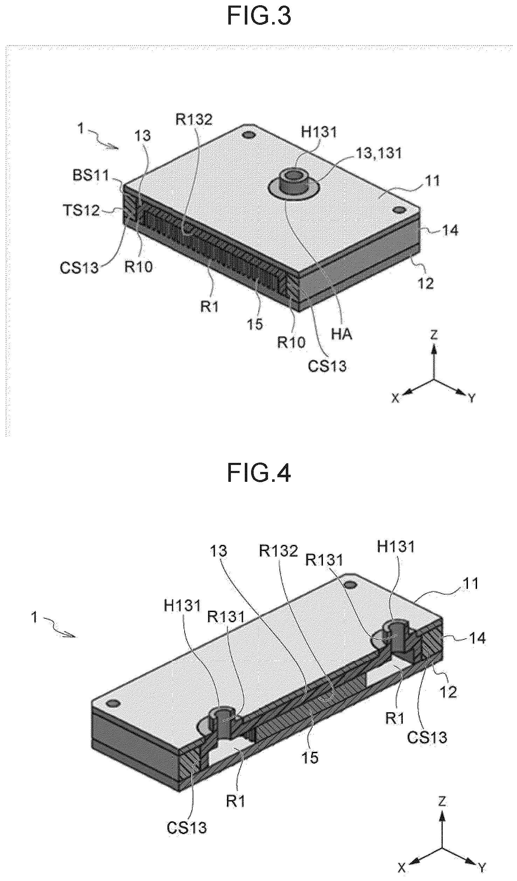

As illustrated in FIG. 1, a temperature control device 1 includes: a first metal plate 11; a second metal plate 12; a resin flow path wall part 13; a resin fixing part 14; and a partition member 15 (see FIGs. 3 to 5). The first metal plate 11 and the second metal plate 12 are one example of the pair of metal plates.

The second metal plate 12, the partition member 15, the resin flow path wall part 13, and the first metal plate 11 are arranged in this order. The resin fixing part 14 contacts the peripheries of the first metal plate 11 and the second metal plate 12, fixing the second metal plate 12 to the first metal plate 11.

The resin flow path wall part 13 has a pair of connecting portions 131 (corresponding to a supply port and a collection port). The pair of connecting portions 131 are connected to an external supply component or discharge unit, and supply or discharge a cooling medium between the outside and the temperature control device 1.

The side of the temperature control device 1 in which one of the connecting portions 131 is arranged is defined as "back side" of the temperature control device 1, and the opposite side thereof is defined as "front side" of the temperature control device 1. When the temperature control device 1 is viewed from the front side, the right-hand side is defined as "right side" of the temperature control device 1, and the opposite side thereof is defined as "left side" of the temperature control device 1. In the direction perpendicular to the front-back direction and the left-right direction of the temperature control device 1, the side in which the first metal plate 11 is arranged is defined as "upper side" of the temperature control device 1, and the opposite side thereof is defined as "lower side" of the temperature control device 1. These orientations do not limit the orientation of the temperature control device of the disclosure during use.

In FIGs. 1 to 5, the front side, the back side, the right side, the left side, the upper side, and the lower side correspond to the X-axis positive direction, the X-axis negative direction, the Y-axis positive direction, the Y-axis negative direction, the Z-axis positive direction, and the Z-axis negative direction, respectively.

The crystallinity of the resin flow path wall part 13 is lower than the crystallinity of the resin fixing part 14. The difference in crystallinity is 3% or more. A method of determining each of the crystallinity of the resin flow path wall part 13 and the crystallinity of the resin fixing part 14 is the same as the method described below in the section of Examples.

The temperature control device 1 has a rectangular parallelepiped shape.

The temperature control device 1 has an upper main surface TS1. On the side of this upper main surface TS1 of the temperature control device 1, the pair of connecting portions 131 of the resin flow path wall part 13 are arranged. As illustrated in FIG. 2, the temperature control device 1 has a lower main surface BS1. The lower main surface BS1 of the temperature control device 1 is in the form of a flat surface.

The inside of the temperature control device 1 has an internal flow path R1. A cooling medium (i.e., one example of the heat exchange medium) is circulated in the internal flow path R1.

Dimensions of the temperature control device 1 are not particularly limited, and may be selected in accordance with the intended use and the like of the temperature control device 1. For example, the lower main surface BS1 of the temperature control device 1 may have an area in a range of from 50 cm² to 5,000 cm². For example, the thickness of the temperature control device 1 in the vertical direction may be in a range of from 1 mm to 50 mm.

### (1.6.1) First Metal Plate

The first metal plate 11 has a flat plate shape. When viewed from the upper side (Z-axis positive direction) toward the lower side (Z-axis negative direction), the shape of the first metal plate 11 is a substantially rectangular shape having its long sides in the front-back direction (X-axis direction).

As illustrated in FIG. 1, the first metal plate 11 has a pair of through-holes HA. One of the pair of through-holes HA is positioned at a central part in the left-right direction (Y-axis direction) and a back part in the front-back direction (X-axis direction) of the first metal plate 11. The other through-hole HA is positioned at a central part in the left-right direction (Y-axis direction) and a front part in the front-back direction (X-axis direction) of the first metal plate 11.

The through-holes HA penetrate the first metal plate 11 along the vertical direction (Z-axis direction). The through-holes HA are in communication with the internal flow path R1 (see FIG. 2) in the temperature control device 1.

Examples of the material of the first metal plate 11 are the same as those metals exemplified above as the material of the pair of metal plates.

### (1.6.2) Second Metal Plate

The second metal plate 12 has a flat plate shape. When viewed from the upper side (Z-axis positive direction) toward the lower side (Z-axis negative direction), the shape of the second metal plate 12 is a substantially rectangular shape having its long sides in the front-back direction (X-axis direction).

Examples of the material of the second metal plate 12 are the same as those metals exemplified above as the material of the pair of metal plates. The material of the second metal plate 12 may be the same as or different from the material of the first metal plate 11.

### (1.6.3) Resin Flow Path Wall Part

The resin flow path wall part 13 has a plate-like shape. An external supply component and an external discharge unit are connected to the resin flow path wall part 13. The resin flow path wall part 13 forms the internal flow path R1 (see FIG. 2) with the second metal plate 12.

The connecting portions 131 are positioned on the upper surface side of the resin flow path wall part 13. As illustrated in FIGs. 3 and 4, the connecting portions 131 are exposed from the respective through-holes HA. The connecting portions 131 each have an opening H131 and a hollow part R131 (see FIG. 4).

A cooling medium is supplied to the opening H131. The opening H131 is positioned on the upper surface of the resin flow path wall part 13. The opening H131 faces upward (Z-axis positive direction).

As illustrated in FIG. 4, the hollow part R131 is formed to connect the opening H131 and the internal flow path R1. The hollow part R131 is formed inside one of the connecting portions 131.

The first metal plate 11 has a lower main surface BS11 (see FIG. 3). At least those portions of the upper surface of the resin flow path wall part 13 that surround the connecting portions 131 physically contacts the lower main surface BS11 of the first metal plate 11. Therefore, the pair of through-holes HA of the first metal plate 11 are each closed by the resin flow path wall part 13.

As illustrated in FIGs. 3 and 4, the resin flow path wall part 13 further has a recessed portion R132. The recessed portion R132 is positioned at a central part in the front-back direction (X-axis direction) and the left-right direction (Y-axis direction) on the lower surface side of the resin flow path wall part 13.

The recessed portion R132 is formed to form the internal flow path R1 in which a cooling medium is circulated, between the recessed portion R132 and the second metal plate 12.

The second metal plate 12 has an upper main surface TS12 (see FIG. 3). At least the portion of the lower surface of the resin flow path wall part 13 that surrounds the recessed portion R132 physically contacts the upper main surface TS12 of the second metal plate 12. Therefore, the internal flow path R1 is formed between the recessed portion R132 and the upper main surface TS12 of the second metal plate 12.

An arithmetic mean roughness Ra of a portion CS13 (see FIGs. 3 and 4) of the resin flow path wall part 13 that contacts the resin fixing part 14 is not particularly limited, and it is from 0.5 µm to 100 µm.

Examples of the material of the resin flow path wall part 13 are the same as those materials exemplified above for the first thermoplastic resin composition. The resin flow path wall part 13 preferably contains a crosslinked-type PPS.

### (1.6.4) Resin Fixing Part

The resin fixing part 14 fixes the second metal plate 12 to the first metal plate 11. In other words, the resin fixing part 14 integrates the first metal plate 11, the second metal plate 12, the resin flow path wall part 13, and the partition member 15.

The resin fixing part 14 and the resin flow path wall part 13 are fused together.

As illustrated in FIG. 3, a void R10 is formed between the first metal plate 11 and the second metal plate 12. The void R10 represents a space between the first metal plate 11 and the second metal plate 12, in which the resin flow path wall part 13 does not contact the peripheries of the first metal plate 11 and the second metal plate 12. The void R10 is formed over the entire circumference of the peripheries of the first metal plate 11 and the second metal plate 12.

The void R10 is filled with the resin fixing part 14. In other words, the resin fixing part 14 physically contacts the periphery of the lower main surface BS11 of the first metal plate 11, the periphery of the upper main surface TS12 of the second metal plate 12, and the side surface of the resin flow path wall part 13.

The surface of the first metal plate 11 that contacts the resin fixing part 14, and the surface of the second metal plate 12 that contacts the resin fixing part 14 have a first uneven structure.

The resin fixing part 14 is formed by insert molding. The resin fixing part 14 contains a resin that is compatible with the resin contained in the resin flow path wall part 13. The resin fixing part 14 preferably contains a linear-type PPS.

### (1.6.5) Partition Member

The partition member 15 divides the internal flow path R1.

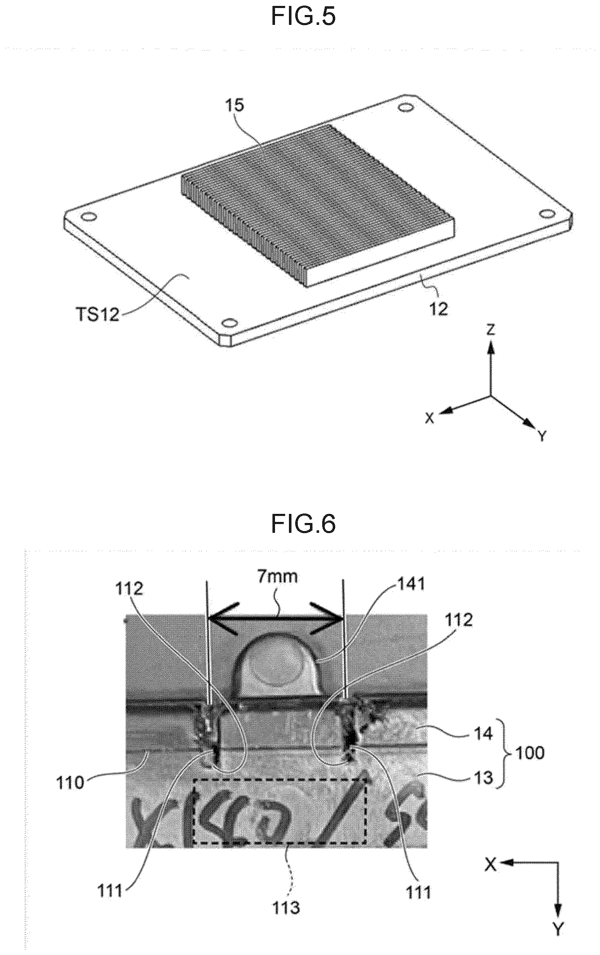

The partition member 15 has plural partition walls. As illustrated in FIG. 5, the plural partition walls are arranged at prescribed intervals along the left-right direction (Y-axis direction). The plural partition walls each have an elongated plate shape. The plural partition walls control the flow direction of a cooling medium.

The partition member 15 may be fixed to the second metal plate 12. Examples of a method of fixing the partition member 15 to the second metal plate 12 include the same methods as those exemplified above as fixing methods.

Examples of the material of the partition member 15 are the same as those materials exemplified above as the material of the partition member. The material of the partition member 15 may be the same as or different from the material of the second metal plate 12 or the resin flow path wall part 13.

### (1.6.6) Flow of Cooling Medium

The temperature control device 1 is installed and used such that, for example, the lower main surface BS1 of the temperature control device 1 contacts a heat-generating body (i.e., one example of the heat exchange object). In this case, an external supply component is connected to one of the connecting portions 131. An external discharge unit is connected to the other connecting portion 131. The heat of the heat-generating body is conducted through at least one of the first metal plate 11 or the second metal plate 12 to a cooling medium filled into the internal flow path R1.

The cooling medium is supplied to the opening H131 of one of the connecting portions 131. The cooling medium supplied to the opening H131 moves to the internal flow path R1 via the hollow part R131 of the connecting portion 131. Most of the cooling medium moves in the internal flow path R1 toward the other connecting portion 131. In this process, the cooling medium exchanges heat with at least one of the first metal plate 11 or the second metal plate 12.

Subsequently, the cooling medium moves to the opening H131 through the hollow part R131 of the other connecting portion 131, and is discharged to the external discharge unit.

In this manner, the cooling medium absorbs heat from the heat-generating body inside the temperature control device 1, and is discharged to the outside of the temperature control device 1. By this, the temperature control device 1 facilitates heat dissipation of the heat-generating body. In other words, the temperature control device 1 controls the temperature of the heat-generating body.

### (1.6.7) Actions and Effects

As described above referring to FIGs. 1 to 5, the temperature control device 1 includes: the first metal plate 11; the second metal plate 12; the resin flow path wall part 13; and the resin fixing part 14. The resin fixing part 14 fixes the second metal plate 12 to the first metal plate 11. The internal flow path R1 is formed by the second metal plate 12 and the resin flow path wall part 13. The resin fixing part 14 and the resin flow path wall part 13 are fused together. The crystallinity of the resin flow path wall part 13 is lower than the crystallinity of the resin fixing part 14. The difference in crystallinity is 3% or more.

By this, a higher degree of freedom in the design of the internal flow path R1 is obtained as compared to a case of using a flow path wall part made of a metal.

In addition, the resin flow path wall part 13 and the resin fixing part 14 are more likely to be fused together as compared to a case where the difference in crystallinity, which is calculated by subtracting the crystallinity of the resin flow path wall part from the crystallinity of the resin fixing part, is less than 3%. Further, it is believed that crystals are more likely to be formed in a plane where the resin flow path wall part 13 and the resin fixing part 14 are fused together. By this, the strength of a fused portion of the resin flow path wall part 13 and the resin fixing part 14 is improved. In other words, even when a pressurized cooling medium is circulated in the internal flow path R1, the cooling medium is unlikely to leak from the fused portion of the resin flow path wall part 13 and the resin fixing part 14. As a result, the temperature control device 1 has an excellent air tightness.

Therefore, the temperature control device 1 has an excellent degree of freedom in the design of the internal flow path R1 as well as an excellent air tightness.

It is preferred that the resin flow path wall part 13 contains a crosslinked-type PPS and the resin fixing part 14 contains a linear-type PPS. This further improves the strength of the fused portion of the resin flow path wall part 13 and the resin fixing part 14. As a result, the temperature control device 1 attains a superior air tightness.

As described above referring to FIGs. 1 to 5, the first metal plate 11 and the second metal plate 12 each have a first uneven structure on their parts contacting the resin fixing part 14. This allows the resin fixing part 14 to be partially incorporated into recesses of the first uneven structure of each of the first metal plate 11 and the second metal plate 12. As a result, the first metal plate 11 and the second metal plate 12 are each more strongly bonded with the resin fixing part 14. The air tightness of the temperature control device 1 can thus be maintained over a longer period.

As described above referring to FIGs. 1 to 5, the resin fixing part 14 is formed by insert molding. This allows the resin fixing part 14 to be more certainly incorporated into the gaps of the uneven parts of the surfaces contacting each of the first metal plate 11 and the second metal plate 12. Therefore, the resin fixing part 14 is more strongly anchored with the first metal plate 11 and the second metal plate 12. As a result, the air tightness of the temperature control device 1 can be maintained over a longer period.

As described above referring to FIGs. 1 to 5, an arithmetic mean roughness Ra of the portion CS13 of the resin flow path wall part 13 that contacts the resin fixing part 14 is not particularly limited, and it is from 0.5 µm to 100 µm. By this, the fusion strength is improved as compared to a case where the arithmetic mean roughness Ra of the portion CS13 of the resin flow path wall part 13 that contacts the resin fixing part 14 is outside the range of from 0.5 µm to 100 µm.

### (2) Second Embodiment

The temperature control device according to a second embodiment of the disclosure includes a pair of metal plates, a resin flow path wall part, and a resin fixing part. The resin flow path wall part is sandwiched between the pair of metal plates. The resin fixing part fixes one of the pair of metal plates to the other metal plate. An internal flow path for circulating a heat exchange medium is formed by at least one of the pair of metal plates and the resin flow path wall part. The resin fixing part and the resin flow path wall part are fused together. The crystallinity of the resin flow path wall part as measured by X-ray diffractometry is lower than the crystallinity of the resin fixing part as measured by X-ray diffractometry. The resin flow path wall part contains a crosslinked-type thermoplastic resin, and the resin fixing part contains a linear-type thermoplastic resin.

The temperature control device according to the second embodiment has the above-described configuration and is, therefore, excellent in terms of the degree of freedom in the design of the internal flow path as well as the air tightness.

This effect is presumably attributed to, but not limited to, the following reasons.

The temperature control device according to the second embodiment includes the resin flow path wall part. Thus, the internal flow path has a higher degree of design freedom as compared to a case of using a flow path wall part made of a metal.

The crystallinity of the resin flow path wall part is lower than the crystallinity of the resin fixing part. The resin flow path wall part contains a crosslinked-type thermoplastic resin, and the resin fixing part contains a linear-type thermoplastic resin. Accordingly, in the second embodiment, the resin flow path wall part and the resin fixing part are easily fused together. In this case, it is believed that the molecular chain of the resin constituting the resin flow path wall part and the molecular chain of the resin constituting the resin fixing part are entangled with each other in a greater amount. Further, it is believed that crystals are likely to be formed in a plane where the resin flow path wall part and the resin fixing part are fused together. By this, the strength of the fused portion of the resin flow path wall part and the resin fixing part is improved. In other words, even when a pressurized heat exchange medium is circulated in the internal flow path, the heat exchange medium is unlikely to leak from the fused portion of the resin flow path wall part and the resin fixing part. As a result, the temperature control device according to the second embodiment has an excellent air tightness.

For these reasons, it is presumed that the temperature control device according to the second embodiment has an excellent degree of freedom in the design of the internal flow path as well as an excellent air tightness.

In the second embodiment, the resin flow path wall part is the same as the resin flow path wall part of the first embodiment, except that the resin flow path wall part of the second embodiment contains a crosslinked-type thermoplastic resin in place of the thermoplastic resin. This crosslinked-type thermoplastic resin is any thermoplastic resin whose molecular weight has been increased by a heat treatment or the like. The crosslinked-type thermoplastic resin is believed to have a long-chain branched structure, rather than a network crosslinked structure such as that of a thermosetting resin.

In the second embodiment, the resin fixing part is the same as the resin fixing part of the first embodiment, except that the resin fixing part of the second embodiment contains a linear-type thermoplastic resin in place of the thermoplastic resin. This linear-type thermoplastic resin is any thermoplastic resin that is, for example, a linear polymer whose molecular weight has been increased in the polymerization stage.

The temperature control device according to the second embodiment has the same configuration as the temperature control device according to the first embodiment, except that it is essential that the resin flow path wall part contains a crosslinked-type thermoplastic resin and the resin fixing part contains a linear-type thermoplastic resin, instead of that the difference in crystallinity is 3% or more. Therefore, description of the configuration of the temperature control device according to the second embodiment is omitted.

### (3) Third Embodiment

The temperature control device according to a third embodiment of the disclosure includes a pair of metal plates, a resin flow path wall part, and a resin fixing part. The resin flow path wall part is sandwiched between the pair of metal plates. The resin fixing part fixes one of the pair of metal plates to the other metal plate. An internal flow path for circulating a heat exchange medium is formed by at least one of the pair of metal plates and the resin flow path wall part. The resin fixing part and the resin flow path wall part are fused together. The resin flow path wall part contains a crosslinked-type polyphenylene sulfide, and the resin fixing part contains a linear-type polyphenylene sulfide.

The temperature control device according to the third embodiment has the above-described configuration and is, therefore, excellent in terms of the degree of freedom in the design of the internal flow path as well as the air tightness.

This effect is presumably attributed to, but not limited to, the following reasons.

The temperature control device according to the third embodiment includes the resin flow path wall part. Thus, the internal flow path has a higher degree of design freedom as compared to a case of using a flow path wall part made of a metal. The resin flow path wall part contains a crosslinked-type PPS, and the resin fixing part contains a linear-type PPS. In other words, the resin flow path wall part is more easily melted than the resin fixing part. Accordingly, in the third embodiment, the resin flow path wall part and the resin fixing part are more easily fused together as compared to when the resin flow path wall part contains a linear-type PPS and the resin fixing part contains a crosslinked-type PPS. In this case, it is believed that the molecular chain of the resin constituting the resin flow path wall part and the molecular chain of the resin constituting the resin fixing part are entangled with each other in a greater amount. Further, it is believed that crystals are likely to be formed in a plane where the resin flow path wall part and the resin fixing part are fused together. By this, the strength of the fused portion of the resin flow path wall part and the resin fixing part is improved. In other words, even when a pressurized heat exchange medium is circulated in the internal flow path, the heat exchange medium is unlikely to leak from the fused portion of the resin flow path wall part and the resin fixing part. As a result, the temperature control device according to the third embodiment has an excellent air tightness.

For these reasons, it is presumed that the temperature control device according to the third embodiment has an excellent degree of freedom in the design of the internal flow path as well as an excellent air tightness.

The temperature control device according to the third embodiment has the same configuration as the temperature control device according to the first embodiment, except that it is essential that the resin flow path wall part contains a crosslinked-type PPS and the resin fixing part contains a linear-type PPS, instead of that the crystallinity of the resin flow path wall part is lower than the crystallinity of the resin fixing part. Therefore, a description of the configuration of the temperature control device according to the third embodiment is omitted.

### (4) Method of Producing Temperature Control Device

The method of producing a temperature control device according to the disclosure is a method of producing the temperature control device of the disclosure. The method of producing a temperature control device according to the disclosure includes preparing the above-described resin flow path wall part by injection molding (hereinafter, also referred to as "injection molding step"). An inner surface of a mold used for the injection molding includes a molding surface for molding a portion of the resin flow path wall part that contacts the above-described resin fixing part. The molding surface has a fine uneven structure (hereinafter, also referred to as "second uneven structure").

The "inner surface of a mold" refers to a wall surface constituting a cavity. The "cavity" refers to a space in a mold used for forming an injection-molded product by filling thereto a resin composition.

The method of producing a temperature control device according to the disclosure is configured as described above and, therefore, can yield a temperature control device having a superior fusion strength.

This effect is presumably attributed to, but not limited to, the following reasons.

In the disclosure, the molding surface, which is a part of the inner surface of a mold, has a second uneven structure. By this, the second uneven structure of the inner surface of the mold is transferred to a portion of the resulting resin flow path wall part that contacts the resin fixing part. In other words, the resulting resin flow path wall part has the second uneven structure at a portion contacting the resin fixing part. When the portion of the resin flow path wall part that contacts the resin fixing part has the second uneven structure, the area where the resin flow path wall part and the resin fixing part contact each other is further increased. As a result, a temperature control device having a superior fusion strength is presumed to be obtained.

### (4.1) Injection Molding Step

The method of producing a temperature control device according to the disclosure includes the injection molding step. In the injection molding step, as described above, the resin flow path wall part is prepared by injection molding. By this, the resin flow path wall part that has a fine uneven structure at a portion contacting the resin fixing part is obtained.

For the injection molding, an injection molding machine is employed. The injection molding machine is equipped with a mold, a known injection device, and a known clamping device. The mold includes a movable-side mold and a fixed-side mold. The fixed-side mold is fixed to the injection molding machine. The movable-side mold is movable with respect to the fixed-side mold. The injection device injects a molten resin composition into a sprue of the mold at a prescribed injection pressure. The clamping device clamps the movable-side mold at a high pressure such that the movable-side mold is not opened by the filling pressure of the molten resin composition.

The inner surface of the mold includes a molding surface. The molding surface is a part of the inner surface of the mold. The molding surface has the second uneven structure. Other parts of the inner surface of the mold that are different from the molding surface may also have the second uneven structure.

An arithmetic mean roughness Ra of the second uneven structure is not particularly limited, and it is preferably from 0.5 µm to 100 µm, more preferably from 1 µm to 60 µm, still more preferably from 10 µm to 30 µm.

The arithmetic mean roughness (Ra) is determined by a method according to JIS B0601.

The portion of the resulting resin flow path wall part that contacts the resin fixing part has the arithmetic mean roughness Ra of the second uneven structure.

### (4.2) Step of Grinding Molding Surface of Mold

The method of producing a temperature control device according to the disclosure may also include performing a roughening treatment on the molding surface of the mold (hereinafter, also referred to as "grinding step"). The grinding step is performed prior to the injection molding step. By this, the second uneven structure can be formed on the molding surface of the mold.

A method of the roughening treatment is not particularly limited, and examples of the roughening treatment include a blast treatment, a grinding treatment, and an etching treatment. These roughening treatments may be performed singly, or in combination of two or more thereof. Examples of the blast treatment include shot blasting, sand blasting, and grid blasting. Examples of the grinding treatment include grinding with a grinding material (e.g., an abrasive paper (i.e., a sandpaper), a grinding roll, or a metal brush). Examples of the etching treatment include an acid treatment with a strong acid (e.g., sulfuric acid or nitric acid). As the roughening treatment, from the standpoint of further improving the fusion strength, a grinding treatment and a blast treatment are preferably performed in this order.

### (4.2) Roughening Step of Resin Flow Path Wall Part

The method of producing a temperature control device according to the disclosure preferably includes performing a roughening treatment on the portion of the resin flow path wall part that contacts the resin fixing part (hereinafter, also referred to as "roughening step"). The roughening step is performed after the injection molding step. When the method of producing a temperature control device includes the roughening step, the contact portion of the resin flow path wall part is made rougher as compared to when the method does not include the roughening step. In other words, the surface area of the contact portion of the resin flow path wall part is increased. As a result, the fusion strength is improved.

A method of the roughening treatment is not particularly limited, and examples thereof include the same ones as those exemplified above for the roughening treatment of the grinding step.

### EXAMPLES

The disclosure will now be described in more detail by way of Examples; however, the inventions of the disclosure are not limited only to the below-described Examples.

Products that were used in Examples and Comparative Examples are as follows.

### <Thermoplastic Resin Compositions>

- Crosslinked-type PPS composition (A): "SGX-140" manufactured by Tosoh Corporation (resin component: crosslinked-type PPS, filler: glass fiber, glass fiber content: 40% by mass)
- Crosslinked-type PPS composition (B): "SGX-120" manufactured by Tosoh Corporation (resin component: crosslinked-type PPS, filler: glass fiber, glass fiber content: 20% by mass)
- Linear-type PPS composition (C): "1135MF1" manufactured by Polyplastics Co., Ltd. (resin component: linear-type PPS, filler: glass fiber, glass fiber content: 35% by mass)
- Linear-type PPS composition (D): "1140A6" manufactured by Polyplastics Co., Ltd. (resin component: linear-type PPS, filler: glass fiber, glass fiber content: 40% by mass)

### [1] Example 1

A temperature control device 1 (see FIGs. 1 to 5) having a tab 141 (see FIG. 6) on a side surface was produced in the following manner.

### First Preparation Step

Aluminum flat plates were prepared as a first metal plate 11 and a second metal plate 12.

### Second Preparation Step

As a resin flow path wall part 13, an injection-molded product made of the crosslinked-type PPS composition (A) was prepared. Specifically, the resin flow path wall part 13 was obtained by performing the below-described grinding step and injection molding step in this order.

### [1.2.1] Step of Grinding Molding Surface of Mold

A molding surface of the inner surface of a mold used for injection molding, which molding surface was to be used for molding a portion CS13 of the resin flow path wall part 13 contacting the resin fixing part 12, was ground using a sandpaper (#800). The molding surface of the mold had the second uneven structure.

### [1.2.2] Injection Molding Step

Using the mold having the molding surface with the second uneven structure, the resin flow path wall part 13 was prepared by injection molding. The portion CS13 of the resin flow path wall part 13 contacting the resin fixing part 12 had an arithmetic mean roughness Ra of 0.5 µm.

### Insertion Step

One side of the resin flow path wall part 13 was preheated for 5 minutes using a 130°C hot plate. The thus preheated resin flow path wall part 13 was sandwiched between the first metal plate 11 and the second metal plate 12 to obtain a layered body.

This layered body was inserted into a mold, and the linear-type PPS composition (C) was injection-molded in the mold under the below-described molding conditions to form the resin fixing part 14 on the side circumferential surface of the layered body, whereby a temperature control device 1 having a tab 141 on a side surface was obtained. The tab 141 is a part of the resin fixing part 14.

### <Molding Conditions>

Injection molding machine: JT40RADS (vertical injection molding machine), manufactured by JSW
Cylinder temperature: 320°C
Mold temperature: 140°C
Primary injection pressure: 60 MPa
Maintained pressure: 40 MPa
Injection rate: 20 mm/s

### [2] Example 2

A temperature control device 1 having a tab 141 on a side surface was obtained in the same manner as in Example 1, except that the molding surface of the mold on which a grinding treatment was performed was further subjected to a blast treatment to perform texturing. In this blast treatment, alumina particles were sprayed to the molding surface of the mold to form a second uneven structure.

Using the mold having the molding surface with the second uneven structure, the resin flow path wall part 13 was prepared by injection molding. The portion CS13 of the resin flow path wall part 13 contacting the resin fixing part 12 had an arithmetic mean roughness Ra of 10 µm.

### [3] Example 3

A temperature control device 1 having a tab 141 on a side surface was obtained in the same manner as in Example 2, except that, in the insertion step, both sides of the resin flow path wall part 13 were preheated for 40 seconds using a 130°C hot plate. In the blast treatment, alumina particles were sprayed to the molding surface of the mold to form a second uneven structure.

Using the mold having the molding surface with the second uneven structure, the resin flow path wall part 13 was prepared by injection molding. The portion CS13 of the resin flow path wall part 13 contacting the resin fixing part 12 had an arithmetic mean roughness Ra of 10 µm.

### [4] Comparative Examples 1 to 3

Temperature control devices 1 each having a tab 141 were obtained in the same manner as in Example 1, except that the first thermoplastic resin composition and the second thermoplastic resin composition were changed as shown in Table 1, and the grinding step was not performed.

### [5] Measurement of Arithmetic Mean Roughness Ra

The surface roughness was measured at six different measurement locations under the below-described measurement conditions, and an average of six measured values was defined as the arithmetic mean roughness (Ra) of the molding surface of the mold.

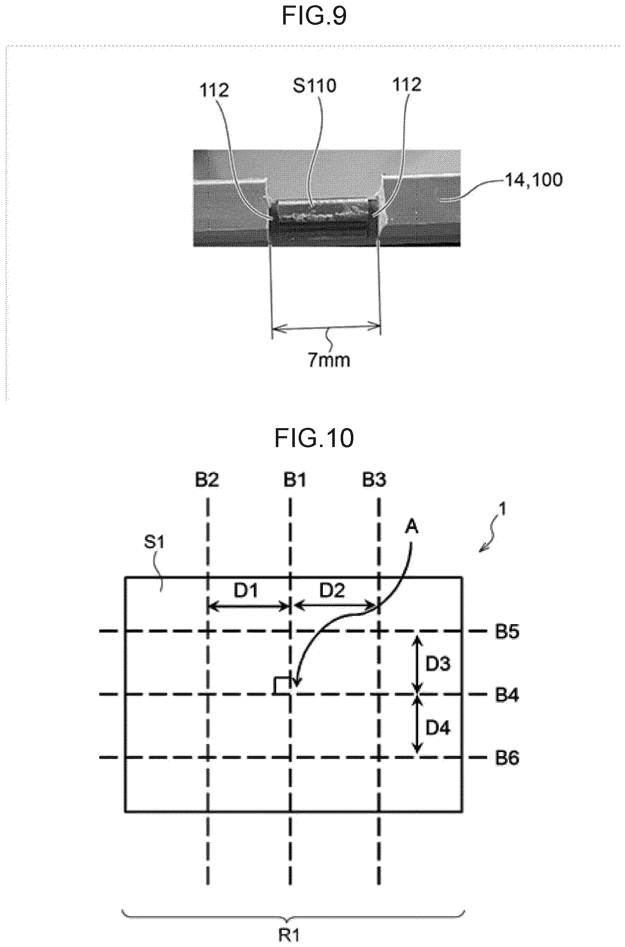

FIG. 10 is a schematic front view of a molding surface S1 of a mold 1, illustrating a method of measuring the surface roughness. As illustrated in FIG. 10, measurement locations are six linear parts B1 to B6 of the molding surface S1 of the mold 1. These six linear parts B 1 to B6 consist of three arbitrary linear parts B1 to B3, and three linear parts B4 to B6 that are perpendicular to the three linear parts B1 to B3. Specifically, the linear part B 1 runs through a central part A of the molding surface S1 of the mold 1. The linear parts B 1 to B3 are parallel to each other. The linear part B4 also runs through the central part A of the molding surface S1 of the mold 1. The linear part B4 and the linear part B 1 intersect at a right angle in the central part A. The linear parts B4 to B6 are parallel to each other. Intervals D1 to D4 between adjacent linear parts were from 2 mm to 5 mm.

### <Surface Roughness Measurement Conditions>

• Measurement device: surface roughness analyzer "SURFCOM 1400D" (manufactured by Tokyo Seimitsu Co., Ltd.)
• Method: stylus method
• Stylus tip radius: 5 µm
• Standard length: 0.8 mm
• Evaluation length: 4 mm
• Measurement speed: 0.06 mm/sec

### [6] Measurement of Crystallinity

For each temperature control device 1 having the tab 141, the crystallinity of the resin flow path wall part 13 and that of the resin fixing part 14 were measured in the following manner.

From the temperature control device 1 having the tab 141, the first metal plate 11 and the second metal plate 12 were separated to obtain a first test specimen.

The thus obtained first test specimen was cut as appropriate, and mounted on a sample stage of the measurement device. Using a camera attached to the measurement device, a measurement spot of the resin flow path wall part 13 and that of the resin fixing part 14 of the first test specimen were specified. At these measurement spots of the resin flow path wall part 13 and the resin fixing part 14, XRD measurement was performed by a reflection method under the following measurement conditions to obtain XRD profiles.

### Measurement Conditions

Measurement device: "SmartLab", manufactured by Rigaku Corporation
X-ray source: CuKα radiation
Attachment: microscopic measurement optical system unit "CBO-f"
Output: 45 kV, 200 mA
Measurement range: from 5° to 60°
Scanning speed: 2°/min
Step width: 0.04°
Detector: "D/tex Ultra"

Using the thus obtained XRD profiles, the crystallinity was calculated by the below-described equation for each of the resin flow path wall part 13 and the resin fixing part 14. The thus calculated values were defined as the crystallinity of each of the resin flow path wall part 13 and the resin fixing part 14 of the temperature control device 1. The calculation results are shown in Table 1.

In the XRD profiles, an amorphous region is believed to include a halo caused by the glass fibers contained in each of the resin flow path wall part 13 and the resin fixing part 14. The calculation of the crystallinity was made based on the obtained XRD profiles without separating the effects of the halo. This is because the effects of such halo cannot be separated in XRD profiles.

### Equation of Crystallinity

Crystallinity (%) = [Peak area derived from crystal portion/(Peak area derived from crystal part + Halo area derived from amorphous portion)] × 100

### [7] Tensile Test

For each temperature control device 1 having the tab 141, the tensile strength was measured in the following manner.

From the temperature control device 1 having the tab 141, the first metal plate 11 and the second metal plate 12 were separated to obtain a second test specimen 100 (see FIG. 6). By a tensile test, it was confirmed that the resin flow path wall part 13 and the resin fixing part 14 were fused together. In FIG. 6, a symbol 110 represents a boundary between the resin flow path wall part 13 and the resin fixing part 14.

As illustrated in FIG. 6, in the front-back direction (X-axis direction), a pair of notches 111 was formed at the base near the respective edges of the test specimen 100. These notches 111 were formed along the left-right direction (Y-axis direction) from the side surface of the test specimen 100 on the left side (Y-axis negative direction) toward the side surface on the right side (Y- axis positive direction). The notches 111 had a length of 4 mm in the left-right direction (Y-axis direction). Ends 112 of the pair of notches 142 on the right side (Y-axis positive direction) were formed in the resin flow path wall part 13. The size of the resin fixing part 14 broken from the resin flow path wall part 13 was 7 mm × 4 mm.

The tensile strength of the second test specimen 100 having the pair of notches 142 was measured by the following method.

Specifically, a tensile tester ("AUTOGRAPH AGS-500-D", manufactured by Shimadzu Corporation) was prepared. This universal material tester has a first chuck and a second chuck. The tab 141 of the second test specimen 100 was held by the first chuck. A holding area 113 (see FIG. 6) of the second test specimen 100 was held by the second chuck. The holding area 113 was located on the right side (Y-axis positive direction) with respect to the ends 112 on the right side (Y-axis positive direction) of the notches 111.

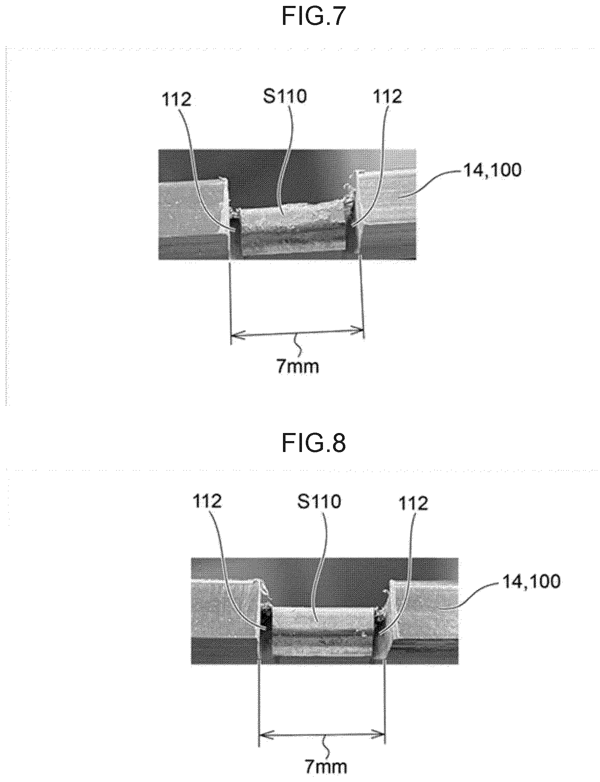

Under the below-described tensile conditions, the first chuck was pulled along the Y-axis positive direction with respect to the second chuck to break the tab 141 from the second test specimen 100. A maximum value of measured tensile strength was defined as the tensile strength of the temperature control device 1. The measurement results are shown in Table 1. FIG. 7 shows an image of a fractured surface of Example 1. FIG. 8 shows an image of a fractured surface of Comparative Example 1. FIG. 9 shows an image of a fractured surface of Comparative Example 2.

An acceptable tensile strength is 250 N or more, and this preferably causes material failure of the resin flow path wall part 13.

### Tensile Conditions

Temperature: room temperature (23°C)
Chuck distance: 50 mm
Tensile speed: 2 mm/min

The chuck distance represents the distance between the first chuck and the second chuck prior to the start of the measurement by the tensile test.

When the fractured surface of Example 1 was observed, it was visually confirmed that, as shown in FIG. 7, mainly an uneven portion of the resin flow path wall part 13 (i.e., material failure of the resin flow path wall part 13) was present in the fractured surface of Example 1. From this result, it was found that the tensile strength of the temperature control device 1 of Example 1 was mainly derived from the mechanical properties of the resin flow path wall part 13. In other words, it was found that the fusion strength of Example 1 was higher than the tensile strength shown in Table 1.

In Example 1, the tensile strength of the resin flow path wall part 13 itself made of the crosslinked-type PPS composition (A) was lower than the tensile strength of the resin fixing part 14 itself made of the linear-type PPS composition (B).

When the fractured surface of Comparative Example 1 was observed, it was visually confirmed that, as shown in FIG. 8, in the fractured surface of Comparative Example 1, mainly a smooth surface of the resin flow path wall part 13 was present with hardly any uneven portion of the resin fixing part 14 (i.e., interfacial failure between the resin flow path wall part 13 and the resin fixing part 14). From this result, it was found that the tensile strength of the temperature control device 1 of Comparative Example 1 was mainly derived from the fusion strength of the resin flow path wall part 13 and the resin fixing part 14.

When the fractured surface of Comparative Example 2 was observed, it was visually confirmed that, as shown in FIG. 9, the fractured surface of Comparative Example 2 mainly had interfacial delamination of the resin flow path wall part 13 and the resin fixing part 14. From this result, it was found that the tensile strength of the temperature control device 1 of Comparative Example 2 was mainly derived from the fusion strength of the resin flow path wall part 13 and the resin fixing part 14. This is believed to be caused by that the resin fixing part 14 was hardly melted, and the resin flow path wall part 13 and the resin fixing part 14 were thus not strongly fused together.

When the fractured surface of Comparative Example 3 was observed, the fractured surface of Comparative Example 3 was found to be the same as the fractured surface of Comparative Example 2. From this result, it was found that the tensile strength of the temperature control device 1 of Comparative Example 3 was mainly derived from the fusion strength of the resin flow path wall part 13 and the resin fixing part 14. This is believed to be caused by that the resin fixing part 14 was hardly melted, and the resin flow path wall part 13 and the resin fixing part 14 were thus not strongly fused together.

In Comparative Examples 2 and 3, the tensile strength of the resin fixing part 14 itself made of the crosslinked-type PPS composition (A) was lower than the tensile strength of the resin flow path wall part 13 itself made of the linear-type PPS composition (B).

**[Table 1]**

| | Resin flow path wall part | Resin fixing part | Resin flow path wall part | | | | Temperature control panel | | | |
|---|---|---|---|---|---|---|---|---|---|---|
| | First thermoplastic composition | Second thermoplastic composition | Surface roughness Ra | Preheating | | | Crystallinity (%) | | Tensile test | |
| | | | | Heated surface | Heating temperature | Heating time | | | Mode of breakage | Tensile strength |
| | | | µm | | °C | seconds | Resin flow path wall part | Resin fixing part | | (N) |
| Example 1 | crosslinked-type PPS composition (A) | linear-type PPS composition (C) | 0.5 | one side | 130 | 300 | 29 | 32 | material failure of resin flow path wall part | 289 |
| Example 2 | crosslinked-type PPS composition (A) | linear-type PPS composition (C) | 10 | one side | 130 | 300 | 29 | 32 | material failure of resin flow path wall part | 334 |
| Example 3 | crosslinked-type PPS composition (A) | linear-type PPS composition (C) | 10 | both sides | 130 | 40 | 26 | 32 | material failure of resin flow path wall part | 482 |
| Comparative Example 1 | crosslinked-type PPS composition (A) | crosslinked-type PPS composition (8) | - | one side | 130 | 300 | 28 | 30 | interfacial failure | 242 |
| Comparative Example 2 | linear-type PPS composition (D) | linear-type PPS composition (C) | - | one side | 130 | 300 | 34 | 33 | interfacial delamination | 202 |
| Comparative Example 3 | linear-type PPS composition (D) | crosslinked-type PPS composition (B) | - | one side | 130 | 300 | 37 | 27 | interfacial delamination | 183 |

In Table 1, "material failure of resin flow path wall part" indicates that mainly the resin flow path wall part 13 was broken; "interfacial failure" indicates that mainly the fusion between the resin flow path wall part 13 and the resin fixing part 14 was broken; and "interfacial delamination of resin fixing part" indicates that mainly the fused resin flow path wall part 13 and resin fixing part 14 were delaminated.

In Examples 1 to 3, the temperature control device 1 includes the first metal plate 11, the second metal plate 12, the resin flow path wall part 13, and the resin fixing part 14. The resin fixing part 14 fixes the second metal plate 12 to the first metal plate 11. The internal flow path R1 is formed by the second metal plate 12 and the resin flow path wall part 13. The resin fixing part 14 and the resin flow path wall part 13 are fused together. The crystallinity of the resin flow path wall part 13 (29%) was lower than the crystallinity of the resin fixing part 14 (32%). The difference in crystallinity was 3%, which is 3% or more. The resin flow path wall part 13 contained a crosslinked-type PPS, while the resin fixing part 14 contained a linear-type PPS.

Therefore, the temperature control devices 1 of Examples 1 to 3 had a tensile strength of 289 N or more, which is 250 N or more. From this result, it was found that the temperature control devices of Examples 1 to 3 had an excellent air tightness. Further, the resin flow path wall part 13 was an injection-molded product. Therefore, it was found that the resin flow path wall part 13 had an excellent degree of freedom in the design of the internal flow path.

According to these results, the temperature control devices of Examples 1 to 3 were found to be excellent in both the degree of freedom in the design of the internal flow path and the air tightness.

On the other hand, in Comparative Example 1, the crystallinity of the resin flow path wall part 13 (28%) was lower than the crystallinity of the resin fixing part 14 (30%). The difference in crystallinity was 2%, which is less than 3%. In Comparative Example 1, the resin flow path wall part 13 contained a crosslinked-type PPS; however, the resin fixing part 14 did not contain a linear-type PPS.

Therefore, the temperature control device 1 of Comparative Example 1 had a tensile strength of 242 N, which is less than 250 N. From this result, it was found that the temperature control device of Comparative Example 1 did not have a sufficient air tightness.

According to these results, it was found that the temperature control device 1 of Comparative Example 1 was excellent in neither the degree of freedom in the design of the internal flow path, nor the air tightness.

In Comparative Examples 2 and 3, the crystallinity of the resin flow path wall part 13 was higher than the crystallinity of the resin fixing part 14. In Comparative Examples 2 and 3, the resin flow path wall part 13 did not contain a crosslinked-type PPS, and the resin fixing part 14 did not contain a linear-type PPS.

Therefore, the temperature control devices 1 of Comparative Examples 2 and 3 had a tensile strength of 202 N or less, which is less than 250 N. From this result, it was found that the temperature control devices of Comparative Examples 2 and 3 did not have a sufficient air tightness.

According to these results, it was found that the temperature control devices 1 of Comparative Examples 2 and 3 were excellent in neither the degree of freedom in the design of the internal flow path, nor the air tightness.

The disclosure of Japanese Patent Application No. 2022-006623 filed on January 19, 2022, is hereby incorporated by reference in its entirety.

All the documents, patent applications, and technical standards that are described in the present specification are hereby incorporated by reference to the same extent as if each individual document, patent application, or technical standard is concretely and individually described to be incorporated by reference.

## Claims

1. A temperature control device, comprising:
a pair of metal plates;
a resin flow path wall part sandwiched between the pair of metal plates; and
a resin fixing part fixing one of the pair of metal plates to the other metal plate, wherein:
an internal flow path for circulating a heat exchange medium is formed by at least one of the pair of metal plates and the resin flow path wall part,
the resin fixing part and the resin flow path wall part are fused together,
the crystallinity of the resin flow path wall part as measured by X-ray diffractometry is lower than the crystallinity of the resin fixing part as measured by X-ray diffractometry, and
a difference between the crystallinity of the resin flow path wall part and the crystallinity of the resin fixing part is 3% or more.

2. A temperature control device, comprising:
a pair of metal plates;
a resin flow path wall part sandwiched between the pair of metal plates; and
a resin fixing part fixing one of the pair of metal plates to the other metal plate, wherein:
an internal flow path for circulating a heat exchange medium is formed by at least one of the pair of metal plates and the resin flow path wall part,
the resin fixing part and the resin flow path wall part are fused together,
the crystallinity of the resin flow path wall part as measured by X-ray diffractometry is lower than the crystallinity of the resin fixing part as measured by X-ray diffractometry,
the resin flow path wall part comprises a crosslinked-type thermoplastic resin, and
the resin fixing part comprises a linear-type thermoplastic resin.

3. The temperature control device according to claim 1 or 2, wherein:
the resin flow path wall part comprises a crosslinked-type polyphenylene sulfide, and
the resin fixing part comprises a linear-type polyphenylene sulfide.

4. A temperature control device, comprising:
a pair of metal plates;
a resin flow path wall part sandwiched between the pair of metal plates; and
a resin fixing part fixing one of the pair of metal plates to the other metal plate, wherein:
an internal flow path for circulating a heat exchange medium is formed by at least one of the pair of metal plates and the resin flow path wall part,
the resin fixing part and the resin flow path wall part are fused together,
the resin flow path wall part comprises a crosslinked-type polyphenylene sulfide, and
the resin fixing part comprises a linear-type polyphenylene sulfide.

5. The temperature control device according to any one of claims 1 to 4, wherein a fine uneven structure at a portion that contacts the resin fixing part.

6. The temperature control device according to any one of claims 1 to 5, wherein the resin fixing part is formed by insert molding.

7. The temperature control device according to any one of claims 1 to 6, wherein a portion of the resin flow path wall part that contacts the resin fixing part has an arithmetic mean roughness Ra of from 0.5 µm to 100 µm.

8. The temperature control device according to any one of claims 1 to 7, having a tensile strength of from 200 N to 550 N,
wherein the tensile strength represents a maximum value of tensile strength required for breaking the resin fixing part, which has a size of 7 mm × 4 mm, from the resin flow path wall part under conditions of a temperature of 23°C, a chuck distance of 50 mm, and a tensile speed of 2 mm/min.

9. A method of producing a temperature control device, which is a method of producing the temperature control device according to any one of claims 1 to 8, the method comprising preparing the resin flow path wall part by injection molding, wherein:
an inner surface of a mold used for the injection molding comprises a molding surface for molding a portion of the resin flow path wall part that contacts the resin fixing part, and
the molding surface has a fine uneven structure.

10. The method of producing a temperature control device according to claim 9, comprising performing a roughening treatment on the portion of the resin flow path wall part that contacts the resin fixing part.
